# EUROPEAN PATENT SPECIFICATION

(11) **EP 4 270 886 B1**
(45) Date of publication and mention of the grant of the patent: **18.03.2026**
(21) Application number: 22305643.3
(22) Date of filing: 29.04.2022
(51) Int. Cl.: H04L 25/02

(54) **SWITCHABLE TERMINATION RESISTANCE CIRCUIT**
SCHALTBARE ABSCHLUSSWIDERSTANDSSCHALTUNG
CIRCUIT DE RÉSISTANCE À TERMINAISON COMMUTABLE

(43) Date of publication of application: 01.11.2023
(73) Proprietor: NXP USA, Inc., Austin TX 78735 (US)
(72) Inventor: MOURET, Guillaume, 31023 Cedex 1 Toulouse (FR); HUOT-MARCHAND, Alexis N., 31023 Cedex 1 Toulouse (FR); BORDES, Laurent, 31023 Cedex 1 Toulouse (FR)
(74) Representative: Schmütz, Christian Klaus Johannes

(56) References cited:
- CN-U- 212 183 126
- JP-A- 2015 122 656
- US-A- 6 078 204
- US-B1- 6 590 413

## Description

### Field

The disclosure relates to a switchable termination resistance circuit for a transceiver physical layer interface.

### Background

In a communication system comprising a pair of transceivers passing signals along a transmission line, a termination resistance at each transceiver serves to reduce reflections along the transmission line.

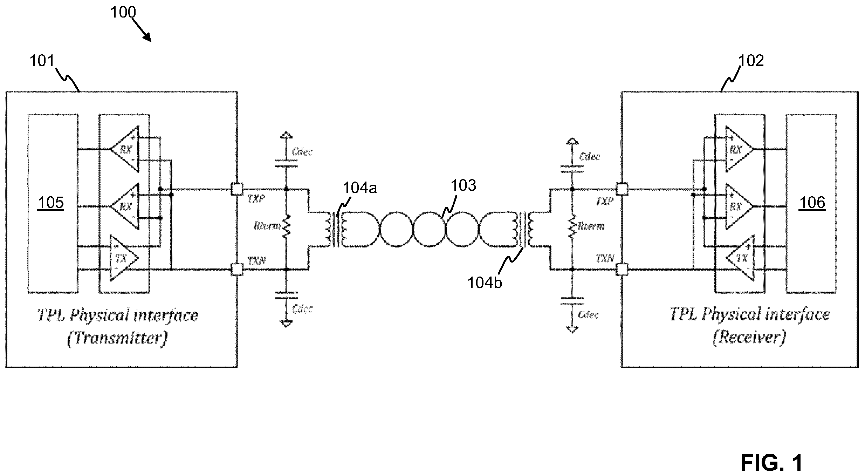

An example of a communication system comprising a pair of transceivers connected by a transmission line is illustrated in Figure 1. The system 100 comprises first and second transceivers 101, 102 connected by a transmission line 103, which in this example comprises a twisted wire pair. Each transceiver 101, 102 is the physical interface of a transformer physical layer (TPL). The transmission line 103 is isolated from the transceivers 101, 102 by a transformer 104a, 104b at either end of the transmission line 103. In the illustrated example, the first transceiver 101 is in transmit mode and the second transceiver 102 is in receive mode. Each transceiver 101, 102 comprises a pair of terminals TXP, TXN that connect to the transmission line 103 via respective transformers 104a, 104b. A termination resistance Rterm is connected between the terminals TXP, TXN. Decoupling capacitors Cdec are connected between each of the terminals TXP, TXN and ground. Each transceiver 101, 102 comprises two receiver amplifiers RX and one transmitter amplifier TX connected between the terminals TXP, TXN and a control module 105, 106.

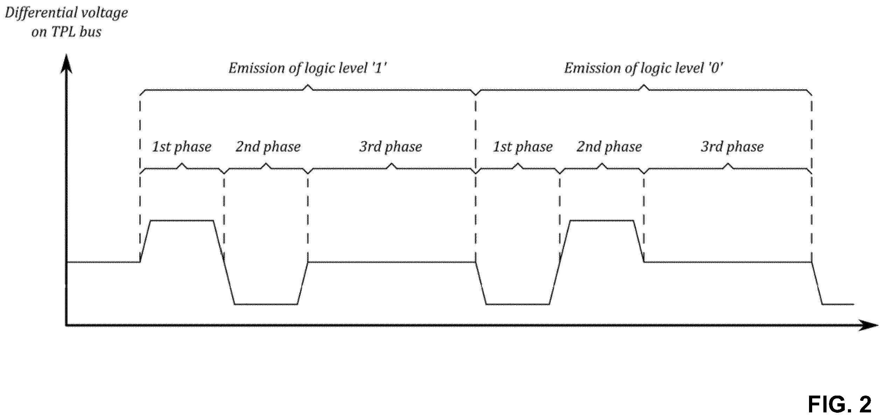

Figure 2 illustrates schematically the differential voltage between terminals TXP, TXN as a function of time at a transmitter during transmission of a logic level 1 followed by a logic level 0. For a logic level 1, the transmitter applies a positive differential voltage during a first phase followed by a negative differential voltage during a second phase, and then followed by a zero differential voltage during a third phase. The duration of the first and second phases is approximately the same, while the duration of the third phase is around twice that of each the first and second phases. For a logic level 0, the transmitter first applies a negative differential voltage during a first phase, followed by a positive differential voltage in a second phase and a zero differential voltage in a third phase. Similar to that for a logic level 1, for the logic level 0 the third phase is around twice the length of each of the first and second phases.

To mitigate line attenuation, the differential voltage applied to the transmission line is made as high as possible. The power consumption of the transmitter mostly depends on the differential voltage applied and the bus load representing the equivalent resistance seen across the output connections TXP, TXN, which will include the termination resistance Rterm at the receiver side.

During the first and second phases, the transmitter power consumption will increase if the termination resistance is connected at the transmitter side. To reduce this, the termination resistance may be disconnected during the first and second phases to save on power consumption by the transmitter. An example of a switchable termination resistance to reduce losses when transmitting a signal along the transmission line is disclosed in WO 88/03731 A1, in which a termination resistor is switched into a transceiver circuit for a set length of time after a transmit/receive signal is enabled that is sufficient to receive the leading edge of a data bit over a transmission line.

For line transmission systems where operation at high voltages under electromagnetic interference is required, for example in automotive applications, the design of a switchable termination resistance may be more complex due to the limited maximum acceptable gate voltage of MOSFETs, high electromagnetic interference and high common mode voltages.
JP 2015 122656 A discloses a data receiving device including: a receiving circuit for receiving the input signals inputted from the differential input terminals; first and second termination resistors each including one side terminal connected to each of the differential input terminals; and a termination resistor switching circuit for switching between connecting the first and second termination resistors between the differential input terminals in accordance with a switching signal and an inverse switching signal. The termination resistor switching circuit includes an NMOS and a PMOS connected in parallel between other side terminals of the first and second termination resistors. The switching signal and the inverse switching signal are inputted to gates of the NMOS and the PMOS, and the ground voltage and power source voltage of the data receiving device are inputted to a back gate.

### Summary

According to the invention there is provided a transceiver, a transmission system and a method of operating a transceiver as defined by the appended claims.

### Brief description of Drawings

Embodiments will be described, by way of example only, with reference to the drawings, in which:
Figure 1 is a diagram of a communication system comprising a pair of transceivers connected with a transmission line;
Figure 2 illustrates a schematic illustration of differential voltage on a transmission line as a function of time;
Figure 3 is a simplified schematic diagram of a switchable termination resistance circuit and associated driving circuit for a transmission line communication system;
Figure 4 is a series of plots of voltage as a function of time for transmission of a series of data bits
Figure 5 is a series of plots of voltage as a function of time illustrating the effect of electromagnetic interference;
Figure 6 is a series of plots of voltage and current as a function of time for transmission of a series of data bits for a transmission system with a switchable termination resistance;
Figure 7 is a series of plots of voltage and current as a function of time for transmission of a series of data bits for a transmission system with a non-switchable termination resistance;
Figure 8 is a schematic diagram of an example transceiver comprising a switchable termination resistance circuit;
Figure 9 is a schematic diagram of an example transmission system; and
Figure 10 is a schematic flow diagram of a method of operating an example transmission system.

**It** should be noted that the Figures are diagrammatic and not drawn to scale. Relative dimensions and proportions of parts of these Figures may be shown exaggerated or reduced in size, for the sake of clarity and convenience in the drawings. The same reference signs are generally used to refer to corresponding or similar feature in modified and different embodiments.

### Detailed description of embodiments

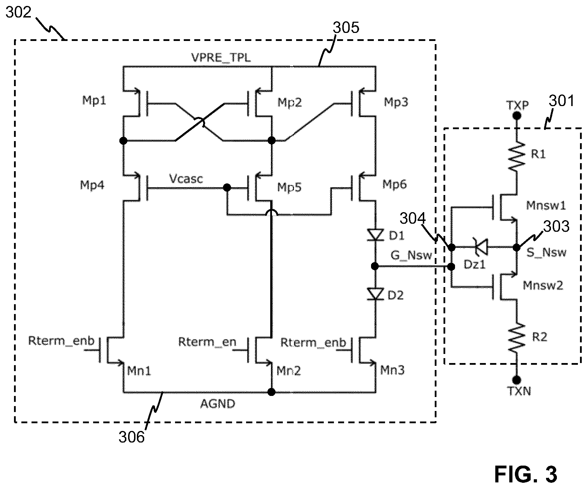

Figure 3 illustrates a schematic diagram of an example switchable termination resistance circuit 301 with an associated driving circuit 302. The switchable termination resistance circuit 301 is connected between first and second terminals TXP, TXN of a transceiver, such as either of the transceivers 101, 102 illustrated in Figure 1. The switchable termination resistance circuit 301 comprises first and second resistors R1, R2 connected to respective first and second terminals TXP, TXN. First and second NMOS termination resistance switches Mnsw1, Mnsw2 are connected in series between the first and second resistors R1, R2. Source connections of the termination resistance switches Mnsw1, Mnsw2 are connected together and drain connections of the termination resistance switches Mnsw1, Mnsw2 are connected to the respective first and second resistors R1, R2. Switching on the first and second termination resistance switches Mnsw1, Mnsw2 by applying a gate voltage to the gates of the termination resistance switches Mnsw1, Mnsw2 connects the first resistor R1 to the second resistor R2 via the first and second termination resistance switches Mnsw1, Mnsw2, thereby connecting a termination resistance between the first and second terminals TXP, TXN. The total termination resistance comprises the first and second resistors R1, R2 in series, together with the source-drain resistances of the first and second termination resistance switches Mnsw1, Mnsw2 (which may be a few Ohms). Switching off the first and second termination resistance switches Mnsw1, Mnsw2 disconnects the termination resistance from the first and second terminals TXP, TXN, leaving the connection between terminals TXP, TXN open circuit.

Gate connections of the first and second termination resistance switches Mnsw1, Mnsw2 are connected to an input node 304, which is connected to an output of the driving circuit 302 for driving the switchable termination resistance circuit 301. Source connections of the first and second termination resistance switches Mnsw1, Mnsw2 are connected together at a midpoint node 303 of the switchable termination resistance circuit 301. A Zener diode Dz1 is connected between the input node 304 and the midpoint node 303, the cathode of the Zener diode Dz1 being connected to the input node 304. The Zener diode Dz1 maintains a gate-source voltage across the first and second termination resistance switches Mnsw1, Mnsw2 within a set voltage range defined by the breakdown voltage of the Zener diode. The Zener diode Dz1 thereby allows the switchable termination resistance circuit 301 to operate in the presence of electromagnetic interference, which may result in high voltages being induced across the first and second terminals TXP, TXN. The Zener diode may for example clamp the gate-source voltage across the termination resistance switches Mnsw1, Mnsw2 to 5V when the switchable terminal resistance circuit 301 is enabled.

During normal operation in the absence of electromagnetic interference, the common mode voltage on the transmission line connected to the first and second connections TXP, TXN may for example be around 2.5 V. To operate the switches Mnsw1, Mnsw2 a voltage at the input node 304 will need to be higher than around 5.5 V, but lower than the breakdown voltage of the Zener diode Dz1.

The driving circuit 302 provides the gate voltage G_Nsw to the input node 304 that operates the first and second termination resistance switches Mnsw1, Mnsw2. The driving circuit 302 is connected between a supply voltage line 305 providing a supply voltage VPRE_TPL (for example 7V) and a ground voltage line 306 at a ground voltage AGND (for example 0V).

The driving circuit 302 operates as a level shifter, allowing a low voltage input signal Rterm_en, Rterm_enb, to drive a higher voltage output signal G_Nsw, and allows the output voltage to float along with the voltage level at the midpoint node 303 of the switchable termination resistance circuit 301. To allow the output voltage to float, the driving circuit 302 comprises first and second diodes D1, D2 connected to the input node 304, the first diode D1 having its cathode connected to the input node 304 and the second diode D2 having its anode connected to the input node 304. Diodes D1, D2 prevent current flowing back into the driving circuit 302 from the switchable termination resistance circuit 301 in the presence of high levels of electromagnetic interference.

First, second and third NMOS switches Mn1, Mn2, Mn3 of the driving circuit 302 have source connections connected to the ground voltage line 305 and gate connections connected to receive a termination resistance enable signal Rterm_en or its inverse, Rterm_enb. Gate connections of the first and third NMOS switches Mn1, Mn3 receive Rterm_enb, while the second NMOS switch Mn2 receives Rterm_en.

The driving circuit 302 further comprises first, second, third, fourth, fifth and sixth PMOS switches Mp1-Mp6. A gate connection of the first PMOS switch Mp1 is connected to a drain connection of the second PMOS switch Mp2. A gate connection of the second PMOS switch Mp2 is connected to a drain connection of the first PMOS switch Mp1. Source connections of the first, second and third PMOS switches are connected to the supply voltage line 304. A gate connection of the third PMOS switch Mp3 is connected to the drain connection of the second PMOS switch Mp2.

A source connection of the fourth PMOS switch Mp4 is connected to the drain connection of the first PMOS switch Mp1 and a drain connection of the fourth PMOS switch Mp4 is connected to a drain connection of the first NMOS switch Mn1. A gate connection of the fourth PMOS switch Mp4 is connected to a gate connection of the fifth PMOS switch Mp5. A source connection of the fifth PMOS switch Mp5 is connected to the drain connection of the second PMOS switch Mp2. A drain connection of the fifth PMOS switch Mp5 is connected to a drain connection of the second NMOS switch Mn2.

Gate connections of the fifth and sixth PMOS switches Mp5, Mp6 are connected together. A source connection of the sixth PMOS switch Mp6 is connected to a drain connection of the third PMOS switch Mp3. A drain connection of the sixth PMOS switch Mp6 is connected to an anode connection of the first diode D1.

A drain connection of the third NMOS switch Mn3 is connected to the cathode connection of the second diode D2.

To turn on the termination resistance, the enable signal Rterm_en is provided to the second NMOS switch Mn2 and its inverse to the first and third NMOS switches Mn1, Mn3. The voltage applied at the input node 304 is then the supply voltage VPRE_TPL minus one diode voltage, i.e., the voltage across the first diode D1. The supply voltage VPRE_TPL needs to be sufficient to pull the gates of the termination switches Mnsw1, Mnsw2 but lower than that required to drive current through the Zener diode Dz1.

To turn off the termination resistance, the third NMOS switch Mn3 is turned on with Rterm_enb, which pulls down the drain of the NMOS switch Mn3 and the gate voltage at the input node 304 to one diode voltage about ground, thereby turning off the termination resistance switches Mnsw1, Mnsw2.

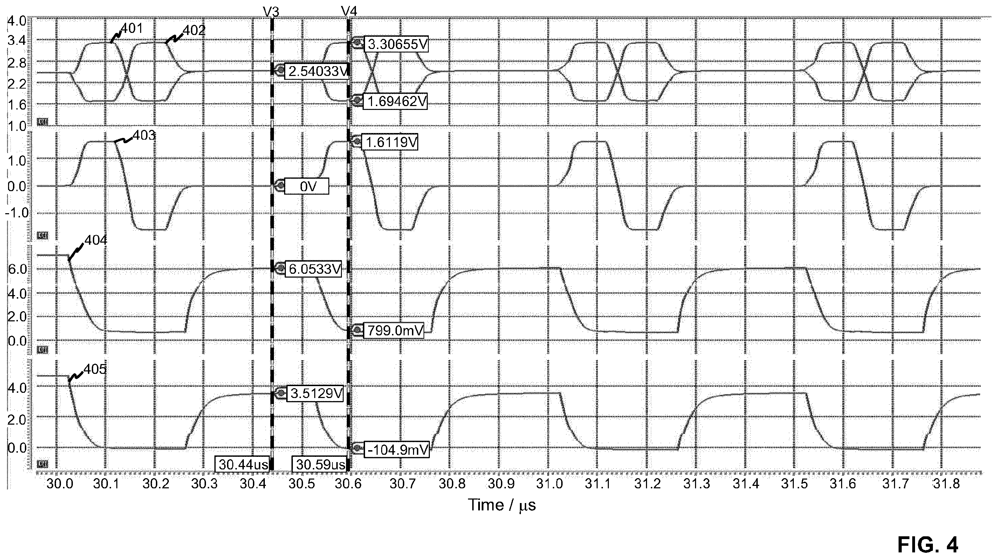

Figure 4 illustrates an example series of plots of voltage as a function of time at various points in the circuit of Figure 3, including the voltages V_TXP 401 and V_TXN 402 at respective terminals TXP, TXN, the differential voltage V_TXP-V_TXN 403 between terminals TXP, TXN, the voltage V_Gnmos 404 on the gates of the termination resistance switches Mnsw1, Mnsw2, and the gate-source voltage V_GS_Nmos 405 across the termination resistance switches Mnsw1, Mnsw2.

During the first and second phase of the transmission of sequential bits, the voltage V_Gnmos 404 falls to around 0.6V and the resulting gate-source voltage 405 across the first and second termination resistance switches Mnsw1, Mnsw2 is around -0.2V, causing the first and second termination resistance switches Mnsw1, Mnsw2 to be off. In this example, the threshold of the termination resistance switches is around 1V. During the third phase, where the differential voltage 403 is zero, the gate voltage V_Gnmos 404 rises to around 6V and the gate-source voltage V_GS_Nmos 405 across the termination resistance switches Mnsw1 Mnsw2 rises to around 3.5V, resulting in the termination resistance being connected between the terminals TXP, TXN. The presence of the termination resistance reduces the effect of any rebound signals in the transmission line during the third phase.

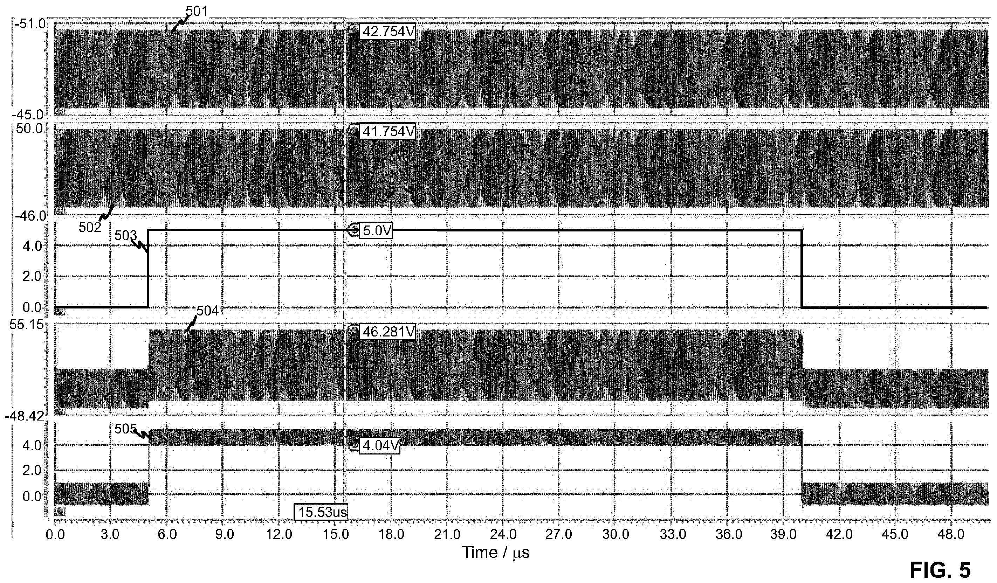

Figure 5 illustrates simulated voltage measurements in the presence of electromagnetic interference, which results in perturbations of around +/- 40V along the transmission line. The plots of voltage as a function of time show voltages V_TXP 501, V_TXN 502 at respective terminals TXP, TXN, the termination resistance enable signal Rterm_en 503, the gate voltage V_Gnmos 504 at the termination resistance switches Mnsw1, Mnsw2 and the gate-source voltage V_GS_nmos 505 across the termination resistance switches Mnsw1, Mnsw2. The voltages 501, 502 on the terminals TXP, TXN oscillate rapidly as a result of the electromagnetic interference. This results in oscillation of the gate voltage V_Gnmos 504 but, because the midpoint node 303 floats, the gate-source voltage V_GS_nmos across the termination resistance switches Mnsw1, Mnsw2 maintains the switches in the required state corresponding to the enable signal 503.

When the enable signal 503 is in a low state, i.e., around 0V, the gate-source voltage 505 across the termination resistance switches oscillates around +/-0.6V, resulting in the termination resistance being disconnected. When the enable signal 503 is in a high state, in this case around 5V, the gate-source voltage 505 across the termination resistance switches rises to between around 4V and 5V, resulting in the termination resistance being connected to the terminals TXP, TXN. Disabling the enable signal 503 then results in the gate-source voltage 505 returning to around +/- 0.6V, thereby deactivating the termination resistance. The termination resistance circuit is therefore shown to work as required even during electromagnetic interference resulting in perturbations as high as +/-40V on the transmission line.

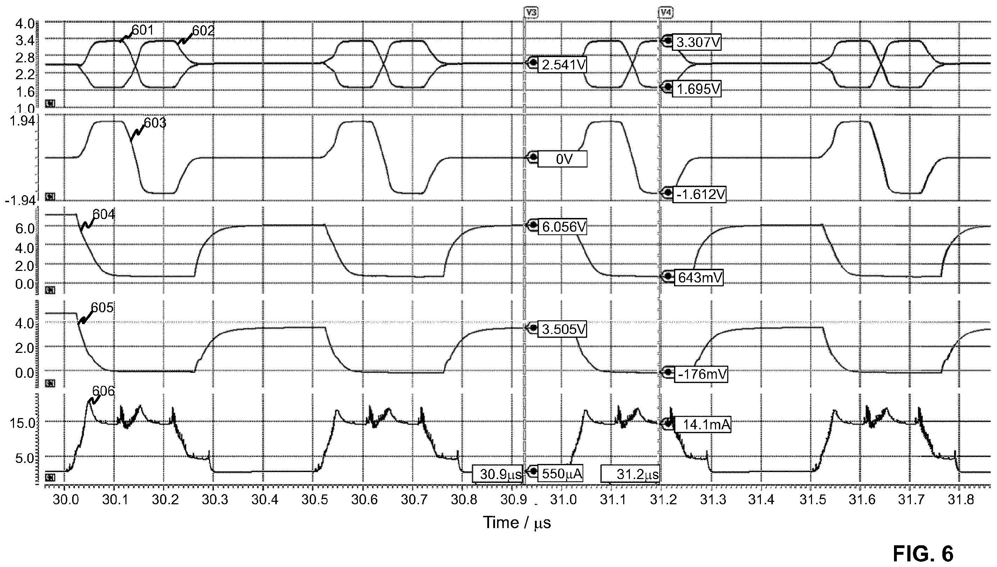

Figure 6 illustrates a further example series of plots of voltage as a function of time at various points in the circuit of Figure 3, including the voltages V_TXP 601 and V_TXN 602 at the respective terminals TXP, TXN, the differential voltage V_TXP-V_TXN 603 between the terminals TXP, TXN, the voltage V_Gnmos 604 on the gates of the termination resistance switches Mnsw1, Mnsw2, and the gate-source voltage V_GS_Nmos 605 across the termination resistance switches Mnsw1, Mnsw2. Also shown in Figure 6 is the current supply I_supply 606, which increases to around 15 mA during the positive and negative phases of the transmission of each bit on the transmission line for a differential voltage of around 1.6V. The main portion of current consumption is that during the first and second phases, which cover around half of the total period for transmission of each bit. The average current consumption over each bit is therefore around 7.5 mA.

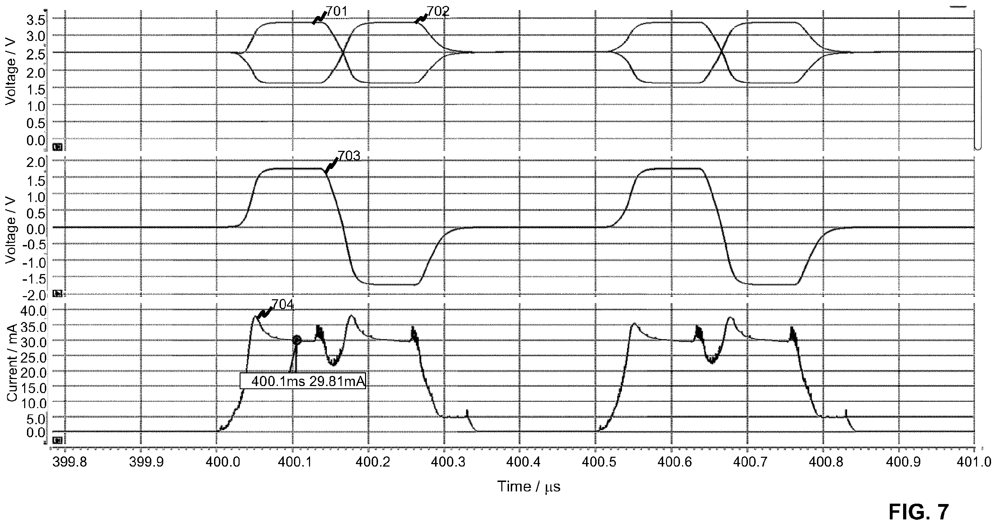

Figure 7 illustrates for comparison a series of plots showing voltages V_TXP 701, V_TXN 702 at terminals TXP, TXN, the resulting differential voltage 703 and current 704 as a function of time for a transmission line system without a switchable termination resistance. For a similar differential voltage of around +/- 1.6V, the average current consumption during the first and second phases is around 30 mA, double that of the current consumption of that with the switchable termination resistance. The use of a switchable termination resistance can therefore result in a halving of the overall current consumption.

A problem with incorporating termination resistances in integrated circuits is that the value of resistance may vary significantly, for example by around +/-20%. This can lead to inaccuracies in operation of the transceiver. To improve matching of the termination resistance to a desired value, a plurality of parallel connected termination resistance circuits may be provided, one of which is selected as the closest to the desired value. The chosen resistance may therefore more closely match the desired value. As an example, if a desired value for the termination resistance is Rterm, a first termination resistance circuit with nominal values of 0.8Rterm/2 for each resistor R1 and R2, a second termination resistance circuit with nominal values of Rterm/2 for R1 and R2 and a third termination resistance circuit with nominal values of 1.2Rterm/2 for R1 and R2 may be provided and the one most closely matching the desired total termination resistance Rterm selected during manufacture.

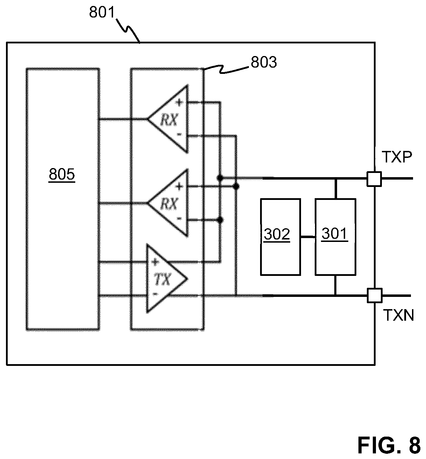

Figure 8 is a schematic diagram of an example transceiver 801 with a switchable termination resistance circuit 301 of the type described herein. The transceiver 801 comprises a control module 805 configured to provide signals to and receive signals from an amplifier module 803, which is similar to that described above in relation to Figure 1, i.e., with two receiver amplifiers RX and one transmitter amplifier TX. The amplifier module 803 is connected to terminals TXP, TXN for connection to a transmission line, for example a transmission line of the type shown in Figure 1. The switchable termination resistance circuit 301 is connected between the terminals TXP, TXN. A driving circuit 302 is configured to provide a gate driving voltage to the switchable termination resistance circuit 301 to switch the circuit 301 on and off. Operation of the driving circuit 302 is controlled by the control module 805, which provides a termination resistance enable signal to the driving circuit 302.

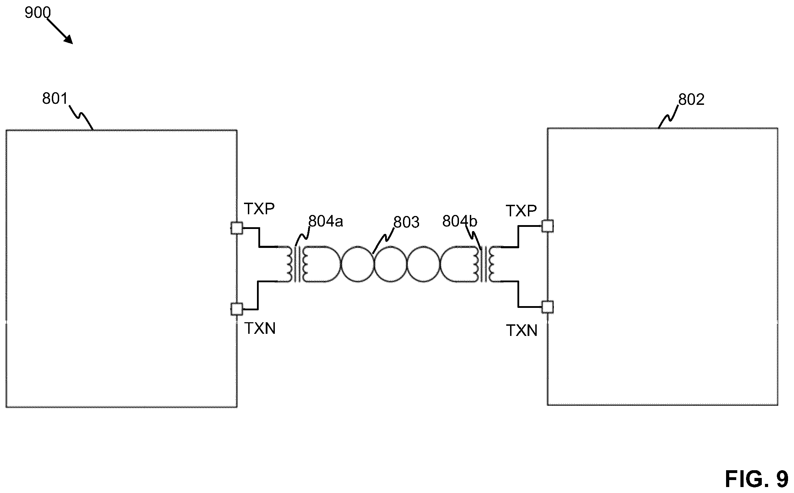

A simplified transmission system 900 is illustrated schematically in Figure 9. The transmission system 900 comprises first and second transceivers 801, 802 of the type described above in relation to Figure 8. Each transceiver 801, 802 comprises first and second terminals TXP, TXN connected to respective ends of a transmission line 803. The transmission line 803 comprises transformers 804a, 804b at each end to isolate the transceivers 801, 802 from the transmission line 803.

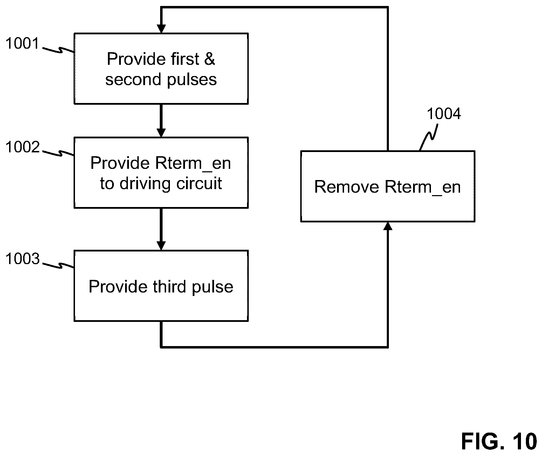

Figure 10 is a schematic flow diagram illustrating a series of method steps describing operation of the transmission system. In a first step 1001, the first and second pulses are provided to the amplifier module for transmission. In a second step 1002, following transmission of the first and second pulses, the termination resistance enable signal Rterm_en is provided to the driving circuit (together with its inverse, Rterm_enb) and in a third step 1003 the third pulse is provided. The process then repeats for transmission of each subsequent data bit, with the termination resistance enable signal Rterm_en removed (step 1004) prior to providing subsequent first and second pulses for the subsequent data bit.

The transmission system described herein may be particularly applicable in battery management systems, for example for vehicle battery systems, in which isolated electrical communication is required, current consumption is a critical parameter and electromagnetic interference may be high. The transmission system described herein may also be applicable in other applications where isolated transmission with a low current consumption, particularly in the presence of high electromagnetic interference, may be required.

From reading the present disclosure, other variations and modifications will be apparent to the skilled person. Such variations and modifications may involve equivalent and other features which are already known in the art of transmission line transceivers, and which may be used instead of, or in addition to, features already described herein.

## Claims

1. A transceiver (801) comprising:
first and second terminals (TXP, TXN) for connection to a transmission line (103);
a control module (805);
an amplifier module (803) connected between the control module (805) and the first and second terminals (TXP, TXN); and
a switchable termination resistance circuit (301) connected between the first and second terminals (TXP, TXN) the switchable termination resistance circuit (301) comprising:
first and second NMOS termination resistance switches (Mnsw1, Mnsw2) having source connections connected together at a midpoint node (303) and gate connections connected to an input node (304);
a first resistor (R1) connected between the first terminal (TXP) and a drain connection of the first NMOS termination resistance switch (Mnsw1);
a second resistor (R2) connected between the second terminal (TXN) and a drain connection of the second NMOS termination resistance switch (Mnsw2); and
a Zener diode (Dz1) having a cathode side connected to the input node (304) and an anode side connected to the midpoint node (303),
the transceiver (801) further comprising a driving circuit (302) configured to provide a gate voltage (G_Nsw) to the input node (304) of the switchable termination resistance circuit (301),
wherein the control module (805) is configured to provide signals to and from the amplifier module (803) and a termination resistance enable signal (Rterm_en) to the driving circuit (302), wherein the driving circuit (302) comprises:
a first diode (D1) connected between a supply voltage line (305) and the input node (304), the first diode (D1) having a cathode connected to the input node (304);
a second diode (D2) connected between the input node (304) and a ground voltage line (306), the second diode (D2) having an anode connected to the input node (304);
first, second and third NMOS switches (Mn1, Mn2, Mn3) having source connections connected to the ground voltage line (306), the control module (805) connected to provide the termination resistance enable signal (Rterm_en) to the gate of the second NMOS switch (Mn2) and an inverse of the termination resistance enable signal (Rterm_enb) to the gates of the first and third NMOS switches (Mn1, Mn3), the drain of the third NMOS switch (Mn3) connected to a cathode of the second diode (D2); and
first, second, third, fourth, fifth and sixth PMOS switches (Mp1-Mp6), wherein:
a gate connection of the first PMOS switch (Mp1) is connected to a drain connection of the second PMOS switch (Mp2);
a gate connection of the second PMOS switch (Mp2) is connected to a drain connection of the first PMOS switch (Mp1);
source connections of the first, second and third PMOS switches (Mp1, Mp2, Mp3) are connected to the supply voltage line (304);
a gate connection of the third PMOS switch (Mp3) is connected to the drain connection of the second PMOS switch (Mp2);
a source connection of the fourth PMOS switch (Mp4) is connected to the drain connection of the first PMOS switch (Mp1);
a drain connection of the fourth PMOS switch (Mp4) is connected to a drain connection of the first NMOS switch (Mn1);
a gate connection of the fourth PMOS switch (Mp4) is connected to a gate connection of the fifth PMOS switch (Mp5);
a source connection of the fifth PMOS switch (Mp5) is connected to the drain connection of the second PMOS switch (Mp2);
a drain connection of the fifth PMOS switch (Mp5) is connected to a drain connection of the second NMOS switch (Mn2);
gate connections of the fifth and sixth PMOS switches (Mp5, Mp6) are connected together;
a source connection of the sixth PMOS switch (Mp6) is connected to a drain connection of the third PMOS switch (Mp3); and
a drain connection of the sixth PMOS switch (Mp6) is connected to an anode connection of the first diode (D1).

2. The transceiver (801) according to claim 1, wherein the transceiver comprises a plurality of switchable termination resistance circuits (301) according to claim 1 connected in parallel between the first and second terminals (TXP, TXN).

3. A transmission system (900) comprising:
first and second transceivers (801, 802) according to claim 1; and
a transmission line (803) connected to first and second terminals (TXP, TXN) of each of the first and second transceivers (801, 802).

4. The transmission system (900) of claim 3, wherein the transmission line (803) comprises first and second transformers (804a, 804b) at each end to isolate the first and second transceivers (801, 802) from the transmission line (803).

5. A method of operating a transceiver according to claim 1, the method comprising transmitting a data bit over the transmission line (803) by:
the control module (805) providing first and second pulses to the amplifier module (803) to drive respective positive and negative differential voltage levels across the first and second terminals (TXP, TXN) during respective first and second time periods; and
the control module (805) providing a termination resistance enable signal (Rterm_en) to the driving circuit (302) and, while the termination resistance enable signal (Rterm_en) is provided, maintaining a zero differential voltage level across the first and second terminals (TXP, TXN) during a third time period.

6. The method of claim 5, further comprising:
the control module (805) removing the termination resistance enable signal (Rterm_en) from the driving circuit (302); and
repeating the method for transmission of a subsequent data bit over the transmission line (803).

## Patentansprüche

1. Sendeempfänger (801), der Folgendes umfasst:
einen ersten und einen zweiten Anschluss (TXP, TXN) zur Verbindung mit einer Übertragungsleitung (103);
ein Steuermodul (805);
ein Verstärkermodul (803), das zwischen dem Steuermodul (805) und dem ersten und zweiten Anschluss (TXP, TXN) verbunden ist; und
eine schaltbare Abschlusswiderstandsschaltung (301), die zwischen dem ersten und zweiten Anschluss (TXP, TXN) verbunden ist, wobei die schaltbare Abschlusswiderstandsschaltung (301) Folgendes umfasst:
einen ersten und einen zweiten NMOS-Abschlusswiderstandsschalter (Mnsw1, Mnsw2) mit Source-Verbindungen, die an einem Mittelpunktknoten (303) miteinander verbunden sind, und Gate-Verbindungen, die mit einem Eingangsknoten (304) verbunden sind;
einen ersten Widerstand (R1), der zwischen dem ersten Anschluss (TXP) und einer Drain-Verbindung des ersten NMOS-Abschlusswiderstandsschalters (Mnsw1) verbunden ist;
einen zweiten Widerstand (R2), der zwischen dem zweiten Anschluss (TXN) und einer Drain-Verbindung des zweiten NMOS-Abschlusswiderstandsschalters (Mnsw2) verbunden ist; und
eine Zener-Diode (Dz1), die eine Kathodenseite, die mit dem Eingangsknoten (304) verbunden ist, und eine Anodenseite, die mit dem Mittelpunktknoten (303) verbunden ist, aufweist,
wobei der Sendeempfänger (801) ferner eine Ansteuerungsschaltung (302) umfasst, die dazu ausgelegt ist, eine Gate-Spannung (G_Nsw) an den Eingangsknoten (304) der schaltbaren Abschlusswiderstandsschaltung (301) bereitzustellen,
wobei das Steuermodul (805) dazu ausgelegt ist, Signale an und von dem Verstärkermodul (803) und ein Abschlusswiderstands-Aktivierungssignal (Rterm_en) an die Ansteuerungsschaltung (302) bereitzustellen, wobei die Ansteuerungsschaltung (302) Folgendes umfasst:
eine erste Diode (D1), die zwischen einer Versorgungsspannungsleitung (305) und dem Eingangsknoten (304) verbunden ist, wobei die erste Diode (D1) eine Kathode aufweist, die mit dem Eingangsknoten (304) verbunden ist;
eine zweite Diode (D2), die zwischen dem Eingangsknoten (304) und einer Massespannungsleitung (306) verbunden ist, wobei die zweite Diode (D2) eine Anode aufweist, die mit dem Eingangsknoten (304) verbunden ist;
einen ersten, zweiten und dritten NMOS-Schalter (Mn1, Mn2, Mn3) mit Source-Verbindungen umfasst, die mit der Massespannungsleitung (306) verbunden sind, wobei das Steuermodul (805) verbunden ist, um das Abschlusswiderstand-Aktivierungssignal (Rterm_en) an das Gate des zweiten NMOS-Schalters (Mn2) und eine Inverse des Abschlusswiderstand-Aktivierungssignals (Rterm_enb) an die Gates des ersten und dritten NMOS-Schalters (Mn1, Mn3) bereitzustellen, wobei der Drain des dritten NMOS-Schalters (Mn3) mit einer Kathode der zweiten Diode (D2) verbunden ist; und
einen ersten, zweiten, dritten, vierten, fünften und sechsten PMOS-Schalter (Mp1-Mp6), wobei:
eine Gate-Verbindung des ersten PMOS-Schalters (Mp1) mit einer Drain-Verbindung des zweiten PMOS-Schalters (Mp2) verbunden ist;
eine Gate-Verbindung des zweiten PMOS-Schalters (Mp2) mit einer Drain-Verbindung des ersten PMOS-Schalters (Mp1) verbunden ist;
Source-Verbindungen des ersten, zweiten und dritten PMOS-Schalters (Mp1, Mp2, Mp3) mit der Versorgungsspannungsleitung (304) verbunden sind;
eine Gate-Verbindung des dritten PMOS-Schalters (Mp3) mit der Drain-Verbindung des zweiten PMOS-Schalters (Mp2) verbunden ist;
eine Source-Verbindung des vierten PMOS-Schalters (Mp4) mit der Drain-Verbindung des ersten PMOS-Schalters (Mp1) verbunden ist;
eine Drain-Verbindung des vierten PMOS-Schalters (Mp4) mit einer Drain-Verbindung des ersten NMOS-Schalters (Mn1) verbunden ist;
eine Gate-Verbindung des vierten PMOS-Schalters (Mp4) mit einer Gate-Verbindung des fünften PMOS-Schalters (Mp5) verbunden ist;
eine Source-Verbindung des fünften PMOS-Schalters (Mp5) mit der Drain-Verbindung des zweiten PMOS-Schalters (Mp2) verbunden ist;
eine Drain-Verbindung des fünften PMOS-Schalters (Mp5) mit einer Drain-Verbindung des zweiten NMOS-Schalters (Mn2) verbunden ist;
Gate-Verbindungen des fünften und sechsten PMOS-Schalters (Mp5, Mp6) miteinander verbunden sind;
eine Source-Verbindung des sechsten PMOS-Schalters (Mp6) mit einer Drain-Verbindung des dritten PMOS-Schalters (Mp3) verbunden ist; und
eine Drain-Verbindung des sechsten PMOS-Schalters (Mp6) mit einer Anodenverbindung der ersten Diode (D1) verbunden ist.

2. Sendeempfänger (801) nach Anspruch 1, wobei der Sendeempfänger eine Vielzahl schaltbarer Abschlusswiderstandsschaltungen (301) nach Anspruch 1 umfasst, die parallel zwischen dem ersten und zweiten Anschluss (TXP, TXN) verbunden sind.

3. Übertragungssystem (900), das Folgendes umfasst:
einen ersten und zweiten Sendeempfänger (801, 802) nach Anspruch 1; und
eine Übertragungsleitung (803), die mit einem ersten und zweiten Anschluss (TXP, TXN) sowohl des ersten als auch des zweiten Sendeempfängers (801, 802) verbunden ist.

4. Übertragungssystem (900) nach Anspruch 3, wobei die Übertragungsleitung (803) einen ersten und zweiten Transformator (804a, 804b) an jedem Ende umfasst, um den ersten und den zweiten Sendeempfänger (801, 802) von der Übertragungsleitung (803) zu isolieren.

5. Verfahren zum Betreiben eines Sendeempfängers nach Anspruch 1, wobei das Verfahren das Übertragen eines Datenbits über die Übertragungsleitung (803) durch Folgendes umfasst:
das Steuermodul (805) stellt dem Verstärkermodul (803) einen ersten und zweiten Impuls bereit, um jeweilige positive und negative Differenzspannungspegel über den ersten und zweiten Anschluss (TXP, TXN) während jeweiliger erster und zweiter Zeiträume anzusteuern; und
das Steuermodul (805) stellt der Ansteuerungsschaltung (302) ein Abschlusswiderstand-Aktivierungssignal (Rterm_en) bereit, und, während das Abschlusswiderstand-Aktivierungssignal (Rterm_en) bereitgestellt wird, behält einen Differenzspannungspegel von Null über den ersten und zweiten Anschluss (TXP, TXN) während eines dritten Zeitraums bei.

6. Verfahren nach Anspruch 5, das ferner Folgendes umfasst:
das Steuermodul (805) entfernt das Abschlusswiderstand-Aktivierungssignal (Rterm_en) von der Ansteuerungsschaltung (302); und
wiederholt das Verfahren zur Übertragung eines nachfolgenden Datenbits über die Übertragungsleitung (803).

## Revendications

1. Émetteur-récepteur (801) comprenant :
des première et deuxième bornes (TXP, TXN) destinées à être connectées à une ligne de transmission (103) ;
un module de commande (805) ;
un module amplificateur (803) connecté entre le module de commande (805) et les première et deuxième bornes (TXP, TXN) ; et
un circuit de résistance de terminaison commutable (301) connecté entre les première et deuxième bornes (TXP, TXN), le circuit de résistance de terminaison commutable (301) comprenant :
des premier et deuxième commutateurs NMOS de résistance de terminaison (Mnsw1, Mnsw2) ayant des connexions de source connectées entre elles au niveau d'un nœud milieu (303) et des connexions de grille connectées à un nœud d'entrée (304) ;
une première résistance (R1) connectée entre la première borne (TXP) et une connexion de drain du premier commutateur NMOS de résistance de terminaison (Mnsw1) ;
une deuxième résistance (R2) connectée entre la deuxième borne (TXN) et une connexion de drain du deuxième commutateur NMOS de résistance de terminaison (Mnsw2) ; et
une diode Zener (Dz1) dont un côté cathode est connecté au nœud d'entrée (304) et un côté anode est connecté au nœud milieu (303),
l'émetteur-récepteur (801) comprenant en outre un circuit de pilotage (302) configuré pour fournir une tension de grille (G_Nsw) au nœud d'entrée (304) du circuit de résistance de terminaison commutable (301),
dans lequel le module de commande (805) est configuré pour fournir des signaux vers et depuis le module amplificateur (803) et un signal d'activation de résistance de terminaison (Rterm_en) au circuit de pilotage (302), le circuit de pilotage (302) comprenant :
une première diode (D1) connectée entre une ligne de tension d'alimentation (305) et le nœud d'entrée (304), la première diode (D1) ayant une cathode connectée au nœud d'entrée (304) ;
une deuxième diode (D2) entre le nœud d'entrée (304) et une ligne de tension de masse (306), la deuxième diode (D2) ayant une anode connectée au nœud d'entrée (304) ;
des premier, deuxième et troisième commutateurs NMOS (Mn1, Mn2, Mn3) ayant des connexions de source connectées à la ligne de tension de masse (306), le module de commande (805) étant connecté pour fournir le signal d'activation de résistance de terminaison (Rterm_en) à la grille du deuxième commutateur NMOS (Mn2) et un inverse du signal d'activation de résistance de terminaison (Rterm_enb) aux grilles des premier et troisième commutateurs NMOS (Mn1, Mn3), le drain du troisième commutateur NMOS (Mn3) étant connecté à une cathode de la deuxième diode (D2) ; et
des premier, deuxième, troisième, quatrième, cinquième et sixième commutateurs PMOS (Mp1-Mp6), dans lequel :
une connexion de grille du premier commutateur PMOS (Mp1) est connectée à une connexion de drain du deuxième commutateur PMOS (Mp2) ;
une connexion de grille du deuxième commutateur PMOS (Mp2) est connectée à une connexion de drain du premier commutateur PMOS (Mp1) ;
des connexions de source des premier, deuxième et troisième commutateurs PMOS (Mp1, Mp2, Mp3) sont connectées à la ligne de tension d'alimentation (304) ;
une connexion de grille du troisième commutateur PMOS (Mp3) est connectée à la connexion de drain du deuxième commutateur PMOS (Mp2) ;
une connexion de source du quatrième commutateur PMOS (Mp4) est connectée à la connexion de drain du premier commutateur PMOS (Mp1);
une connexion de drain du quatrième commutateur PMOS (Mp4) est connectée à une connexion de drain du premier commutateur NMOS (Mn1);
une connexion de grille du quatrième commutateur PMOS (Mp4) est connectée à une connexion de grille du cinquième commutateur PMOS (Mp5) ;
une connexion de source du cinquième commutateur PMOS (Mp5) est connectée à la connexion de drain du deuxième commutateur PMOS (Mp2) ;
une connexion de drain du cinquième commutateur PMOS (Mp5) est connectée à une connexion de drain du deuxième commutateur NMOS (Mn2) ;
des connexions de grille des cinquième et sixième commutateurs PMOS (Mp5, Mp6) sont connectées ensemble ;
une connexion de source du sixième commutateur PMOS (Mp6) est connectée à une connexion de drain du troisième commutateur PMOS (Mp3) ; et
une connexion de drain du sixième commutateur PMOS (Mp6) est connectée à une connexion d'anode de la première diode (D1).

2. Émetteur-récepteur (801) selon la revendication 1, l'émetteur-récepteur comprenant une pluralité de circuits de résistance de terminaison commutable (301) selon la revendication 1 connectés en parallèle entre les première et deuxième bornes (TXP, TXN).

3. Système de transmission (900) comprenant :
des premier et deuxième émetteurs-récepteurs (801, 802) selon la revendication 1 ; et
une ligne de transmission (803) connectée à des première et deuxième bornes (TXP, TXN) de chacun des premier et deuxième émetteurs-récepteurs (801, 802).

4. Système de transmission (900) selon la revendication 3, dans lequel la ligne de transmission (803) comprend des premier et deuxième transformateurs (804a, 804b) à chaque extrémité afin d'isoler les premier et deuxième émetteurs-récepteurs (801, 802) de la ligne de transmission (803).

5. Procédé de fonctionnement d'un émetteur-récepteur selon la revendication 1, le procédé comprenant la transmission d'un bit de données sur la ligne de transmission (803) par :
par le module de commande (805), la fourniture de première et deuxième impulsions au module amplificateur (803) afin de piloter des niveaux de tension différentielle positif et négatif respectifs aux première et deuxième bornes (TXP, TXN) pendant des première et deuxième périodes de temps respectives ; et
par le module de commande (805), la fourniture d'un signal d'activation de résistance de terminaison (Rterm_en) au circuit de pilotage (302) et, pendant la fourniture du signal d'activation de résistance de terminaison (Rterm_en), le maintien d'un niveau de tension différentielle nul aux première et deuxième bornes (TXP, TXN) pendant une troisième période de temps.

6. Procédé selon la revendication 5, comprenant en outre :
par le module de commande (805), la suppression du signal d'activation de résistance de terminaison (Rterm_en) du circuit de pilotage (302) ; et
la répétition du procédé pour la transmission d'un bit de données suivant sur la ligne de transmission (803).
